**Europäisches Patentamt**

**European Patent Office**

**Office européen des brevets**

(19)

(11) Veröffentlichungsnummer: **0 275 862**
**B1**

# (12) EUROPÄISCHE PATENTSCHRIFT

(45) Veröffentlichungstag der Patentschrift:
05.09.90

(51) Int. Cl.⁵: **G01M 1/16**

(21) Anmeldenummer: **87890286.5**

(22) Anmeldetag: **14.12.87**

(54) Einrichtung zur Unwuchterkennung.

(30) Priorität: **15.01.87 AT 67/87**

(43) Veröffentlichungstag der Anmeldung:
**27.07.88 Patentblatt 88/30**

(45) Bekanntmachung des Hinweises auf die Patenterteilung:
**05.09.90 Patentblatt 90/36**

(84) Benannte Vertragsstaaten:
**BE CH DE FR GB IT LI LU NL SE**

(56) Entgegenhaltungen:
**FR-A- 2 496 136**
**GB-A- 2 087 103**

(73) Patentinhaber: **AUSTRIA Antriebstechnik G. Bauknecht Aktiengesellschaft, G.-Bauknecht-Strasse 1, A-8740 Zeltweg-Spielberg (Steiermark)(AT)**

(72) Erfinder: **Mazuheli, Robert, Neugasse 5, A-8734 Grosslobming Steiermark(AT)**
Erfinder: **Beckord, Ulrich, Dipl.-Ing., Westende 5, A-8720 Pausendorf Steiermark(AT)**

(74) Vertreter: **Beer, Manfred, Dipl.-Ing. et al, Lindengasse 8, A-1070 Wien(AT)**

ACTORUM AG

## Beschreibung

Die Erfindung betrifft eine Einrichtung zur Unwuchterkennung an einem über einen Elektromotor angetriebenen Drehteil, wobei aus Schwankungen in der Stromversorgung des Elektromotors in einer angeschlossenen Auswerteeinheit auf die Größe der Unwucht des Drehteiles geschlossen wird.

Bei verschiedensten über Elektromotor angetriebenen Maschinen moderener Konzeption werden in ständig steigendem Ausmaß höhere Drehzahlen verwendet, was insbesonders beispielsweise für Waschmaschinen moderner Konzeption im Hinblick auf deren höchste Schleuderdrehzahl gilt. Nachdem die von Unwuchten im angetriebenen Drehteil, also beispielsweise in der die Wäsche enthaltenden Trommel, resultierenden Zentripetalkräfte mit dem Quadrat der Drehzahl ansteigen, muß insbesondere bei den heutzutage teilweise schon realisierten Schleuderdrehzahlen von 1000 bis 1400 und darüber pro Minute den Unwuchtkräften immer größere Beachtung zukommen.

Da eine Verstärkung beispielsweise des gesamten Schwingsystems einer Waschmaschine wirtschaftlich kaum vertretbar ist, muß getrachtet werden, die tatsächlich auftretenden Unwuchtkräfte so niedrig wie möglich zu halten.

In diesem Zusammenhang sind Einrichtungen bekannt geworden (siehe z.B. DE-OS 3 421 845), bei denen am antreibenden Elektromotor ein Tacho angebaut wird, der zur Unwuchterkennung über die Drehzahlschwankungen dient – bei autretenden unzulässigen Unwuchten, welche bei niedrigeren Drehzahlen festgestellt werden können, kann dann der Hochlauf in die Schleuderdrehzahl abgebrochen werden. Nachteilig bei den genannten bekannten Einrichtungen ist der relativ kostenintensive Tacho, der auch im Hinblick auf Montage und Wartung einen vermehrten Aufwand bedeutet und darüber hinaus in den üblichen Ausführungen zufolge seines Dauermagnetläufers temperatur- und alterungsabhängig ist.

Aus der FR-A 2 496 136 ist eine Einrichtung der eingangs genannten Art bekannt, bei der als Charakteristikum für die Trommelunwucht einer Waschmaschine die Spannung am als Antriebsmotor dienenden Elektromotor überwacht wird. Wenn die Motorspannung über einem bestimmten – auch einstellbaren – Wert liegt, kann geschleudert werden; bei zufolge zu großer Unwucht zeitweise reduzierter Spannung kann nicht zur maximalen Schleuderdrehzahl hochgefahren werden. Nachteilig ist in diesem Zusammenhang insbesonders der relativ hohe schaltungstechnische Aufwand für die Überwachung der Spannung am Antriebsmotor.

Schließlich ist beispielsweise aus der GB-A 2 087 103 die Unwuchterkennung an der Trommel einer Waschmaschine bekannt, wobei der Spannungsabfall an einem Widerstand in der Zuführung des Motorstromes überwacht wird – über die konkrete Ausführung der schaltungstechnischen Maßnahmen in diesem Zusammenhang ist dieser Schrift nichts zu entnehmen.

Aufgabe der vorliegenden Erfindung ist es, eine Einrichtung der eingangs genannten Art so zu verbessern, daß vorhandene Unwuchten des Drehteils zuverlässig und einfach festgestellt werden können, wobei beim Überschreiten von zulässigen Unwuchtwerten ein weiterverwendbares Signal bereitgestellt werden soll.

Nach wie vor ausgehend vom Prinzip der Unwuchterkennung über Drehzahlschwankungen im Antriebssystem wird die gestellte Aufgabe bei einer Einrichtung der genannten Art gemäß der Erfindung dadurch gelöst, daß im Spannungsversorgungskreis des Elektromotors ein Widerstand angeordnet und an den Eingang eines Verstärkers angeschlossen ist und daß am Ausgang des Verstärkers ein Siebkondensator angeordnet ist, der an seinem dem Verstärker abwesandten Anschluß über einen Spannungsteiler am Signaleingang eines Komparators liegt, dessen Ausgang mit einer Auswerteeinheit verbunden ist. Der – wie oben erwähnt beispielsweise aus der GB-A 2 087 103 auch im Zusammenhang mit der Aufnahme einer dem aufgenommenen Motorstrom proportionalen Größe an sich bekannte – Widerstand in der Spannungsversorgung des Elektromotors ist wesentlich kostengünstiger als der Tacho bei den eingangs angesprochenen bekannten Einrichtungen und kann bei frequenzumrichtergesteuerten Motoren im Zwischenstromkreis und bei Kollektormotoren im Motorhauptstromkreis angeordnet sein. Über diesen Widerstand wird der vom Elektromotor aufgenommene Strom in Form des Spannungsabfalls erfaßt und dem Verstärker zugeführt, welcher zunächst den Spannungsabfall aus dem Motorstrom verstärkt, so daß am Ausgang des Verstärkers Gleichspannung mit einem überlagerten Wechselanteil zur Verfügung steht, welche ein dem aufgenommenen Motorstrom und damit der Unwucht proportionales Signal darstellt. Aus diesem Signal wird anschließend der Gleichstrom herausgefiltert; der unwuchtsynchrone, verbleibende Wechselanteil wird dem Komparator zugeführt und mit dessen Schaltschwelle verglichen, was einen schaltungstechnisch insgesamt sehr einfachen und kostengünstigen Aufbau der erfindungsgemäßen Einrichtung zur Unwuchterkennung erlaubt. Das Ausgangssignal des Komparators kann dann über die Auswerteeinheit dazu benutzt werden, um beispielsweise im Zusammenhang mit der angesprochenen Verwendung der erfindungsgemäßen Einrichtung in einer Waschmaschine den Motorhochlauf in die Schleuderdrehzahl bei Überschreiten eines bestimmten Grenzwerts für die Unwucht abzubrechen.

Die Schaltschwelle des Komparators kann in weiterer Ausgestaltung der Erfindung auch einstellbar sein, was die Berücksichtigung beispielsweise von verschiedenen Drehzahlen oder sonstigen Außeneinflüssen ermöglicht.

Im letztgenannten Zusammenhang ist es insbesonders von Vorteil, wenn nach einer weiteren Ausgestaltung der Erfindung für die Vorgabe von drehzahlabhängigen Schaltschwellen ein Mikroprozessor, beispielsweise mit einem integrierten Puls-Pausen-Modulator oder einem D/A-Wandler, vorgesehen ist, was auf einfache Weise eine Erhöhung der Sicherheit gegen unzulässige Unwuchten bei gleichzeitiger Ausnutzung der drehzahlabhängig verschieden großen zulässigen Unwuchten ermöglicht.

Dem Signaleingang des Komparators kann nach einer anderen Weiterbildung der Erfindung ein, vorzugsweise mehrstufiges, R-C-Filter vorgeschaltet sein, was die Eliminierung von nicht unwuchtproportionalen Wechselanteilen ermöglicht und die Ansprechzuverlässigkeit der Einrichtung erhöht.

Dem Ausgang des Komparators kann in weiterer Ausbildung der Erfindung ein R-C-Filter nachgeschaltet sein, dessen Grenzfrequenz kleiner als die Unwuchtfrequenz ist, was ebenfalls die Störsicherheit der Einrichtung verbessert.

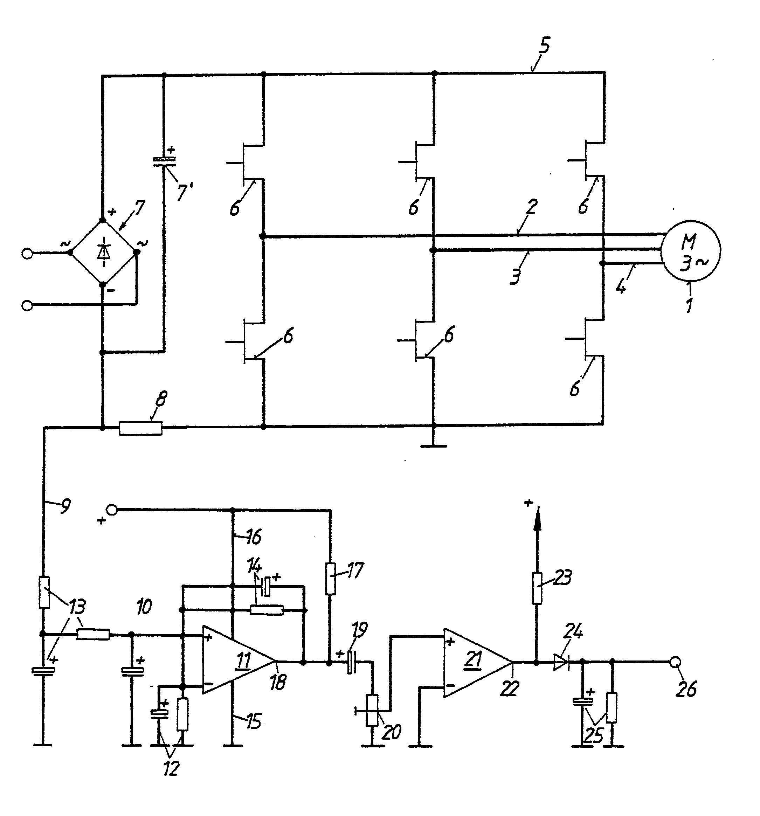

Die Erfindung wird im folgenden anhand der in der Zeichnung in einem teilweise schematischen Schaltbild dargestellten Einrichtung näher erläutert.

Ein als Drehstrom-Asynchronmotor ausgebildeter Elektromotor 1 ist über Spannungsversorgungsleitungen 2, 3, 4 mit einer Drehstrombrücke 5 verbunden, deren beide Brückenzweige jeweils drei Leistungstransistoren 6 aufweisen, welche auf hier nicht weiter dargestellte Weise mit der zugehörigen Steuerung für die Erzeugung des Drehfelds für den Elektromotor 1 verbunden sind. Die an sich konventionell ausgebildete und hier nicht weiter interessante Drehstrombrücke 5 wird eingangsseitig mit über einen Gleichrichter 7 gerichteter Spannung versorgt; zwischen den Gleichspannungsausgängen des Gleichrichters 7 ist noch ein Siebkondensator 7' eingeschaltet.

Im Bereich der Leistungselektronik links unten ist ein hier im Zwischenstromkreis des Frequenzumrichters eingeschalteter Widerstand 8 zu erkennen, der über Leitungen 9, 10 mit dem nicht invertierenden (+)-Eingang eines Verstärkers 11 in Verbindung steht. Andererseits ist der Widerstand 8 über den unteren Zweig der Drehstrombrücke 5 an Masse gelegt. Der invertierende (-)-Eingang des Verstärkers 11 liegt über eine R-C-Kombination 12 an Masse.

Dem nicht invertierenden Eingang des Verstärkers 11 ist in der Darstellung noch ein aus zwei Widerständen und zwei an Masse liegenden Kondensatoren bestehendes zweistufiges Filter 13 vorgeschaltet, um nur die niederfrequenten Schwankungen der am Widerstand 8 abfallenden und dem augenommenen Motorstrom proportionalen Spannung durchzulassen. Die gleiche Aufgabe haben im übrigen auch die R-C-Kombinationen 12 (oben bereits erwähnt) und 14.

Der Verstärker 11 ist über Leitungen 15, 16 mit Masse bzw. seiner Versorgungsspannung verbunden, wobei die Leitung 16 zusätzlich noch über einen Widerstand 17 mit dem Ausgang 18 rückgekoppelt ist. Am Ausgang 18 des Verstärkers 11 wird auf diese Weise ein Gleichspannungssignal mit einem überlagerten Wechselanteil erhalten, welches dem vom Elektromotor 1 aufgenommenen Strom proportional ist. Der Wechselanteil dieses Signals ist ein unmittelbares Maß für die im Antriebssystem wirkende Unwucht, sodaß nach dem Siebkondensator 19, der den Gleichstromanteil eliminiert, ein unmittelbar die Unwucht repräsentierendes Signal übrigbleibt. Dieses wird über den Spannungsteiler 20 - hier ausgebildet als einstellbares Potentiometer - dem nicht invertierenden (+)-Eingang des Komparators 21 zugeführt und dort mit einer Schaltschwelle verglichen. Zufolge der Einstellbarkeit des Spannungsteilers bzw. einer gleichbedeutenden Verstellbarkeit dieser Schaltschwelle kann eine Grenze für die zulässige Unwuchtgröße vorgegeben werden, die auch abhängig von der beabsichtigten Enddrehzahl des Elektromotors 1 oder sonstigen Kriterien gemacht werden kann.

Der Ausgang 22 des Komparators 21 liegt einerseits über einen Widerstand 23 und einer konstanten Hilfsspannung und andererseits über eine Diode 24 und ein R-C-Filter 25 an einer hier nur schematisch angedeuteten Auswerteeinheit 26. Das R-C-Filter 25 weist eine Grenzfrequenz auf, welche kleiner ist als die Frequenz, bei der die Unwuchtmessung durchgeführt wird, sodaß die Störsicherheit erhöht wird und beim Ansprechen des Komparators 21 zufolge einer unerlaubt großen Unwucht der Auswerteeinheit 26 ein stabiles High-Signal zugeführt wird.

Der Vollständigkeit halber sei hier erwähnt, daß beispielsweise im Zusammenhang mit der Verwendung der besprochenen Einrichtung bei einer Waschmaschine die Unwuchtmessungen etwa im Bereich von 1 bis 2 Hz (bezogen auf den Motorstrom — was etwa 10 Umdrehungen der Trommel pro Minute entspricht) durchgeführt werden.

## Patentansprüche

1. Einrichtung zur Unwuchterkennung an einem über einen Elektromotor angetriebenen Drehteil, wobei aus Schwankungen in der Stromversorgung des Elektromotors in einer angeschlossenen Auswerteeinheit auf die Größe der Unwucht des Drehteiles geschlossen wird, dadurch gekennzeichnet, daß im Spannungversorgungskreis des Elektromotors (1) ein Widerstand (8) angeordnet und an den Eingang eines Verstärkers (11) angeschlossen ist, und daß am Ausgang (18) des Verstärkers (11) ein Siebkondensator (19) angeordnet ist, der an seinem vom Verstärker (11) abgewandten Anschluß über einen Spannungsteiler (20) am Signaleingang (+) eines Komparators (21) liegt, dessen Ausgang (22) mit der Auswerteeinheit (26) verbunden ist.

2. Einrichtung nach Anspruch 1, dadurch gekennzeichnet, daß die Schaltschwelle des Komparators (21) einstellbar ist.

3. Einrichtung nach Anspruch 2, dadurch gekennzeichnet, daß für die Vorgabe von drehzahlabhängigen Schaltschwellen ein Mikroprozessor vorgesehen ist.

4. Einrichtung nach einem der Ansprüche 1 bis 3, dadurch gekennzeichnet, daß dem Signaleingang (+) des Komparators (21) ein, vorzugsweise mehrstufiges, R-C-Filter (12, 13, 14) vorgeschaltet ist.

5. Einrichtung nach einem der Ansprüche 1 bis 4, dadurch gekennzeichnet, daß dem Ausgang (22) des Komparators (21) ein R-C-Filter (25) nachgeschaltet ist, dessen Grenzfrequenz kleiner als die Unwuchtfrequenz ist.

## Claims

1. An apparatus for detecting imbalance on a rotary member which is driven by way of an electric motor, wherein the magnitude of the imbalance of the rotary member is deduced from fluctations in the current supply to the electric motor in an evaluation unit connected thereto, characterised in that a resistor (8) is arranged in the voltage supply circuit of the electric motor (1) and connected to the input of an amplifier (11), and that arranged at the output (18) of the amplifier (11) is a filter capacitor (19) which at its terminal remote from the amplifier (11) is connected by way of a voltage divider (20) to the signal input (+) of a comparator (21), the output (22) of which is connected to the evaluation unit (26).

2. Apparatus according to claim 1 characterised in that the switching threshold of the comparator (21) is adjustable.

3. Apparatus according to claim 2 characterised in that a microprocessor is provided for presetting switching thresholds which are dependant on speed of rotation.

4. Apparatus according to one of Claims 1 to 3 characterised in that connected upstream of the signal input (+) of the comparator (21) is a preferably multi-stage RC-filter (12, 13, 14).

5. Apparatus according to one of claims 1 to 4 characterised in that connected downstream of the output (22) of the comparator (21) is an RC-filter (25) whose limit frequency is lower than the imbalance frequency.

## Revendications

1. Dispositif de détection de balourd d'une pièce rotative entraînée par un moteur électrique, l'importance du balourd de la pièce rotative se déduisant des fluctuations de l'alimentation en courant électrique du moteur électrique dans une unité d'évaluation raccordée, caractérisé en ce que, dans le circuit d'alimentation du moteur électrique (1), est montée une résistance (8) qui est reliée à l'entrée d'un amplificateur (11), et en ce qu'à la sortie (18) de l'amplificateur (11) est monté un condensateur de filtrage (19) dont la borne, qui est à l'opposé de l'amplificateur (11), est reliée, par un réducteur de tension (20), à l'entré de signal (+) d'un comparateur (21) dont la sortie (22) est reliée à l'unité d'évaluation (26).

2. Dispositif suivant la revendication 1, caractérisé en ce que le seuil de commutation du comparateur (21) est réglable.

3. Dispositif suivant la revendication 2, caractérisé en ce que, pour prédéfinir des seuils de commutation dépendant de la vitesse de rotation, est prévu un microprocesseur.

4. Dispositif suivant une des revendications 1 à 3, caractérisé en ce qu'à l'entrée de signal (+) du comparateur (21), est monté en série un filtre RC (12, 13, 14) à plusieurs étages.

5. Dispositif suivant une des revendications 1 à 4, caractérisé en ce que derrière la sortie (22) du comparateur (21), est monté un filtre RC (25) dont la fréquence de coupure est inférieure à la fréquence de balourd.